# EUROPÄISCHE PATENTANMELDUNG

(11) **EP 2 060 326 A2**
(43) Veröffentlichungstag der Anmeldung: **20.05.2009**
(21) Anmeldenummer: 08019802.1
(22) Anmeldetag: 13.11.2008
(51) Int. Cl.: B05B 12/02, B05B 13/02, H01L 21/00, H05K 3/00, B05B 15/04

(54) **Vorrichtung und Verfahren zur einseitigen Nassbehandlung von Gut**

(30) Priorität: 13.11.2007 DE 102007054090
(71) Anmelder: Rena Sondermaschinen GmbH, 78148 Gütenbach (DE)
(72) Erfinder: Hübel,Egon, D-90537 Feucht (DE)
(74) Vertreter: Stürken, Joachim

(57) **Zusammenfassung**

Die Erfindung betrifft die Nassbehandlung der Unterseite von Gut 1 in bevorzugt gleich langen Abschnitten in Transportrichtung, das nacheinander von rotierenden Transportmitteln 14, 15 in einer Durchlaufanlage gefördert wird. Die Behandlung erfolgt mittels spritzender oder schwallender Behandlungsflüssigkeit aus Düsenstöcken 3. Dabei soll die Oberseite des Gutes von der Behandlungsflüssigkeit, die im Arbeitsbehälter nur bis an die Unterseite des Gutes heranreicht, nicht benetzt werden.

Durch die Dimensionierung des Umfanges der rotierenden Transportmittel, der der Länge Lg des zu fördernden Gutes plus der Länge Lqlü der Querlücke 4 in der selben Richtung entspricht, werden in der gesamten Durchlaufanlage gleichbleibende momentane Beziehungen der Lage des Gutes zur Winkelstellung der Transportmittel und der weiteren Konstruktionselemente erreicht. Dies wird zu einer synchronisierten Nockensteuerung einer quer zur Transportrichtung angeordneten Blende 17 genutzt. Diese wird von der Nocke 19 immer dann vor die Düsenlöcher 5 geschwenkt, wenn sich eine Querlücke 4 zwischen zwei aufeinander folgenden Gütern im Bereich der Düsenstöcke 3 befindet. Ein Bespritzen der trockenen Oberseite des Gutes wird dadurch vermieden.

## Beschreibung

Die Erfindung betrifft die Nassbehandlung von Gut in Abschnitten, das nacheinander in einer Durchlaufanlage von rotierenden Transportmitteln gefördert wird. Bei dem Gut handelt es sich z.B. um Substrate als Wafer, Hybride oder Solarzellen, die nur einseitig nass zu behandeln sind. Das Gut wird hierzu beim Transport nur mit der Unterseite mit der Behandlungsflüssigkeit in Kontakt gebracht. Die Oberseite befindet sich dabei über dem Niveau der Behandlungsflüssigkeit im Arbeitsbehälter der Durchlaufanlage. Das Gut soll an dieser Seite weder benetzt noch bespritzt werden. Bei der Nassbehandlung kann es sich z.B. um chemische oder galvanische Prozesse sowie um Reinigungs- oder Spülprozesse handeln.

### Stand der Technik und Nachteile

Eine Durchlaufanlage zur einseitigen Nassbehandlung von Substraten beschreibt die Druckschrift DE 10 2005 062 528 A1. Das Gut wird von einer Fördereinrichtung, die nur untere Transportrollen aufweist, gefördert. Die zu behandelnde Unterseite des Gutes befindet sich über dem Niveau der Behandlungsflüssigkeit, die von Transportrollen mit besonderen Oberflächeneigenschaften an die nass zu behandelnde Oberfläche des Gutes übertragen wird. Ein intensiver Austausch der Behandlungsflüssigkeit am Gut kann dabei nicht erfolgen. Die Oberfläche wird nur benetzt, was für bestimmte Nassprozesse ausreichend sein kann.

Aufgabe der Erfindung ist es, eine Vorrichtung und ein Verfahren zu beschreiben, die es ermöglichen, in Durchlaufanlagen Substrate in horizontaler Ausrichtung nur an der Unterseite mit einer Flüssigkeit zu behandelnden. Dabei soll die Behandlungsflüssigkeit auch bei intensiver Anströmung an die Unterseiten nicht an die Oberseiten der Güter gelangen.

Das Niveau der Behandlungsflüssigkeit reicht hierzu maximal bis an die Unterseiten der Güter heran.

Gelöst wird die Aufgabe durch die Vorrichtung nach Patentanspruch 1 und durch das Verfahren nach Patentanspruch 12. Die Unteransprüche beschreiben vorteilhafte Ausführungen der Erfindung.

Die Erfindung geht davon aus, dass das in der Durchlaufanlage einseitig nass zu behandelnde Gut stets die gleich großen Abmessungen mindestens in der Transportrichtung hat. Dies ist in der Praxis in sehr vielen Fällen gegeben, z.B. bei Solarzellen oder Wafern. Dieses Gut ist im Vergleich zu der Durchlaufanlage klein, so dass mehrere Güter parallel, d.h. nebeneinander und nacheinander in die Durchlaufanlage einfahren. Dabei werden bei der Beschickung zwischen den Gütern Längslücken und Querlücken gebildet. Insbesondere die Querlücken sollen zur Anwendung der Erfindung im Verlauf der Förderung des Gutes durch die meist langen Durchlaufanlagen möglichst konstant bleiben. Bei Bedarf sind Korrekturmittel zur Korrektur von möglicherweise auftretendem Schlupf des Gutes entlang der Förderstrecke einzufügen.

Bei den bevorzugten Ausführungsformen der Erfindung sind folgende weitere Dimensionierungen der Konstruktionselemente erforderlich:

Der Umfang u der Transportmittel, auch Fördermittel genannt, muss so groß gewählt werden, wie die Länge Lg des Gutes plus die Länge Lqlü der Querlücke in Transportrichtung beträgt. Die Summe der Längen Lg + Lqlü wird nachfolgend als Bruttogutlänge Lgbr bezeichnet. Des Weiteren müssen die Antriebe aller Transportmittel untereinander synchronisiert, d.h. in einer unveränderlichen Beziehung stehen. Dies ist bei den bekannten Durchlaufanlagen gegeben. Eine Transmissionswelle entlang der Transportbahn treibt formschlüssig mittels Kegelzahnräder oder Zahnriemen die Wellen der Transportmittel an. Gleiches wird durch elektrische Synchronantriebe erreicht. Unter diesen Voraussetzungen steht jeder Querlücke nach der Förderung einer Bruttogutlänge Lgbr exakt wieder das gleich ausgebildete Konstruktionselement der Durchlaufanlage, z.B. ein Düsenstock gegenüber. Durch Verdrehen und Fixieren der Transportmittel auf ihren Wellen erfolgt die für das Gut günstigste Phaseneinstellung einmalig bei der Inbetriebnahme der Durchlaufanlage. Für einen bestimmten, sich immer wiederholenden Startzeitpunkt des Gutes in die Durchlaufanlage werden die Phasenwinkel ϕ der mit den Transportmitteln rotierenden Mittel zur Steuerung der Anströmung der Unterseite des Gutes so eingestellt und fixiert, dass die Oberseite durch die aus den Düsenstöcken ausströmende Behandlungsflüssigkeit nicht benetzt wird.

Zur Vermeidung von vielen individuellen Einstellungen der Phasenwinkel ϕ einzelner Transportmittel entlang der Durchlaufanlage sind definierte Abstände der Wellen der Transportmittel in Transportrichtung einzuhalten. Der Abstand kann der Bruttogutlänge Lgbr entsprechen. Er kann auch ein Vielfaches oder ein Stammbruchteil von Lgbr betragen. In diesen Fällen ergeben sich zum optimalen Anströmen oder Anschwallen des Gutes gleiche Einstellungen der Phasenwinkel ϕ für die Transportmittel auf allen Wellen der Durchlaufanlage, die Mittel zur Steuerung der Anströmung der Unterseite aufweisen. Dazwischen können auch nicht steuernde rotierende oder nicht rotierende Transportmittel angeordnet sein.

### Figurenbeschreibung

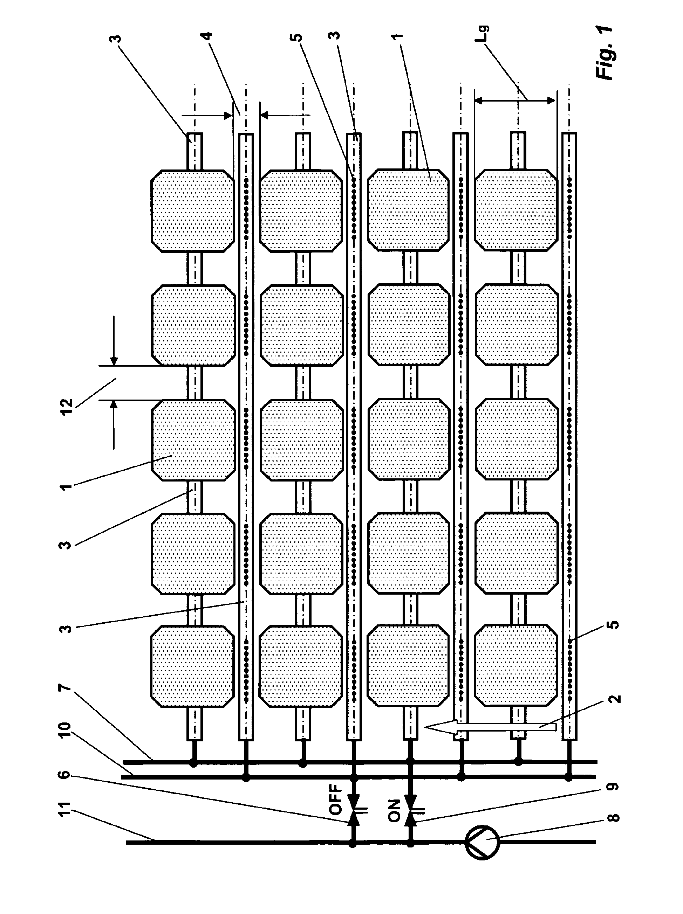

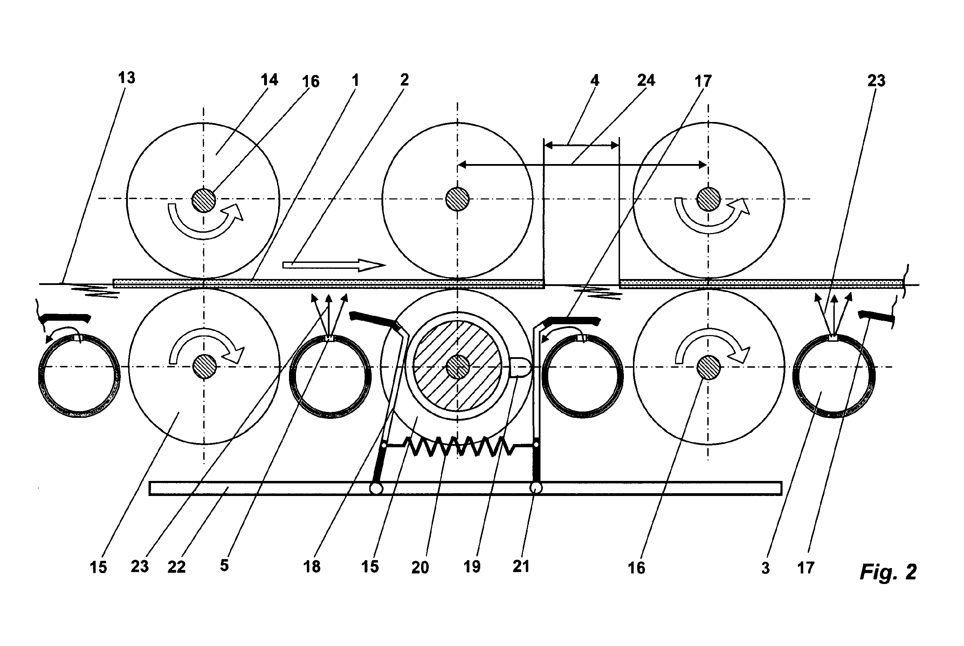

Durch die genannten Voraussetzungen und Dimensionierungen der Konstruktionselemente der Durchlaufanlage ergeben sich besonders vorteilhafte Ausführungen der Erfindung, die nachfolgend an Hand der schematischen und nicht maßstäblichen Figuren 1 und 2 beschrieben werden.

**Figur 1** zeigt in der Draufsicht eine Durchlaufanlage mit fünf Spuren zur parallelen Förderung von fünf Gütern.

**Figur 2** zeigt in der Seitenansicht einen Ausschnitt einer Durchlaufanlage mit unteren und oberen Fördermitteln als Transportwalzen.

In der **Figur 1** sind die Fördermittel für das Gut 1 z.B. als Walzen, Rädchen, Scheiben und dergleichen nicht dargestellt. Desgleichen ihr Antrieb, durch den alle Fördermittel der Durchlaufanlage untereinander synchronisiert sind. Die Durchmesser der Fördermittel und ihre gegenseitigen Wellenabstände sowie die Bruttogutlänge Lgbr sind so dimensioniert, wie es oben beschrieben wurde. Damit tritt die in Figur 1 dargestellte momentane Situation des Transportes der Güter zugleich in der gesamten Durchlaufanlage auf. Jeder zweite Düsenstock 3 oder Sprührohr, der quer zur Transportrichtung 2 angeordnet ist, befindet sich momentan im Bereich einer Querlücke 4. Weil die Behandlungsflüssigkeit unter Druck aus den Düsen 5 oder Düsenlöchern ausströmt, würde diese über das maximal bis an die Unterseite des Gutes 1 heranreichende Niveau hinaus schwallen oder spritzen. Auf diesem Wege würde die Oberseite des Gutes in unzulässiger Weise von der Behandlungsflüssigkeit benetzt werden. Um dies sicher zu vermeiden, werden alle Düsenstöcke 3 rechtzeitig ausgeschaltet, wenn sich ihrem Bereich eine Querlücke 4 nähert.

In Figur 1 wurde für den Abstand der Düsenstöcke in Transportrichtung die halbe Bruttogutlänge Lgbr gewählt. Dies ermöglicht die Bildung von zwei Gruppen der Düsenstöcke. An allen Positionen der Durchlaufanlage treten dadurch in jeder Gruppe die momentan gleichen Situationen der Güter in Bezug zu den Konstruktionselementen der Anlage auf. Jede Gruppe wird von einem gesonderten Verteilerrohr 7, 10 über Ventile 6, 9 oder von individuellen, nicht dargestellten Pumpen mit Behandlungsflüssigkeit gespeist.

In der Figur 1 fördert eine gemeinsame Pumpe 8 die gesamte Behandlungsflüssigkeit im Kreislauf durch die Düsenstöcke 3 und den Arbeitsbehälter in einen Pumpenbehälter, die nicht dargestellt sind. Die Ventile 6, 9 werden vom Steuerungssystem der Durchlaufanlage so geschaltet, dass die Verteilerleitungen 7, 10 nur dann von der Pumpe 8 über ein Speiserohr 11 mit Behandlungsflüssigkeit gespeist werden, wenn sich den jeweiligen Gruppen von Düsenstöcken 3 Güter gegenüber stehen.

Das Steuerungssystem bildet bei der von ihr gesteuerten Beschickung der Durchlaufanlage die unveränderliche Lage aller Querlücken 4 in der gesamten Durchlaufanlage in Bezug zu den Fördermittel und damit auch in Bezug zu den Düsenstöcken 3. Die Querlücke 4 wird mit dem Gut 1 durch die Durchlaufanlage "transportiert". Damit können die Ventile 6, 9 sehr genau ein- und ausgeschaltet werden. Besonders vorteilhaft ist es, dass unter den genannten Voraussetzungen die Düsenstöcke 3 nicht einzeln, sondern in Gruppen oder gemeinsam für die gesamte Durchlaufanlage geschaltet werden können.

Durch das rechtzeitige Ausschalten der Düsenstöcke 3 und entsprechend verzögertes Einschalten nach dem Passieren der Querlücke, gelangt auf diesem Wege keine Behandlungsflüssigkeit an die Oberseite des Gutes. Dies könnte jedoch im Bereich der Längslücken 12 geschehen. Deshalb werden in diesen Bereichen an den Düsenstöcke 3 keine Düsen 5 oder Düsenlöcher angeordnet. Diese Maßnahme kann statisch sein, weil das gleich große Gut 1 bei der Beschickung der Durchlaufanlage stets genau auf den jeweiligen Spuren, die quer zur Transportrichtung vorgegeben sind, aufgelegt werden kann. Damit gelangt auch im Bereich der Längslücken 12 keine Behandlungsflüssigkeit an die Oberseite des Gutes 1.

Das Ein- und Ausschalten der Düsenstöcke 3 erfordert zum Aufbau und zum Abbau des Druckes eine bestimmte kurze Zeit. Diese kann bei einer üblichen Transportgeschwindigkeit des Gutes von z.B. 1 Meter pro Minute vernachlässigt werden. Bei besonders kurzem Gut, z.B. kleiner 100 mm und oder bei einer großen Transportgeschwindigkeit werden erhöhte hydrodynamische Anforderungen gestellt. Hierfür eignet sich die Ausführung der Erfindung gemäß der **Figur 2****.** Der Druck in den Düsenstöcken 3 ist konstant. Er kann von einer oder mehreren Pumpen in der Anlage bei der Kreislaufförderung der Behandlungsflüssigkeit aufgebaut und gehalten werden. Das Niveau 13 der Behandlungsflüssigkeit wird wieder, z.B. mittels Überläufe, im Arbeitsbehälter so eingestellt, dass die Behandlungsflüssigkeit höchstens die Unterseite des Gutes 1 erreicht. Die oberen Transportmittel 14 sind mit ihren bevorzugt angetriebenen Wellen 16 z.B. so gelagert, dass sie in den Zeitabschnitten der Querlücken 4 in ihrem Bereich nicht das Niveau 13 der Behandlungsflüssigkeit erreichen und damit nicht benetzt werden. Die unteren Transportmittel befinden sich in der Behandlungsflüssigkeit. Sie werden ebenfalls von angetriebenen Wellen 16 gelagert. Alle angetriebenen Wellen sind untereinander, wie beschrieben, synchronisiert. Hierdurch ist auch das in Transportrichtung 2 geförderte Gut 1 einschließlich der Querlücke 4 synchronisiert, d.h. bei und nach jeder Umdrehung des Fördermittels hat das Gut immer die gleiche Lage in Bezug zu den Fördermittel und zu den stationären Düsenstöcken 3. Dies wird zum synchronisierten Unterbrechen der Behandlungsflüssigkeit, die aus den Düsenstöcken 3 in Richtung zum Gut 1 ausströmt, mittels einer Nockensteuerung genutzt.

Eine Blende 17, die sich quer zur Transportrichtung des Gutes erstreckt, ist mindestens an einer beweglichen Lasche 18 angeordnet. Die Blende 17 wird immer dann über die Düsen 5 oder Düsenlöcher um den Drehpunkt 21 verlagert oder geschwenkt, wenn sich im Bereich der Düsenstöcke 3 eine Querlücke 4 befindet. Dadurch wird die strömende Behandlungsflüssigkeit von der Blende 17 abgelenkt und sie gelangt nicht über das Niveau 13 der Behandlungsflüssigkeit im Arbeitsbehälter hinaus. Die Oberseite des Gutes, insbesondere die Randbereiche an der vorlaufenden und rücklaufenden Kante werden dadurch nicht benetzt. Nach dem Passieren der Querlücke schwenken die Laschen 18 mit den Blenden 17 wieder zurück. Die Schwenkbewegung wird von einer Nocke 19, die mit dem unteren Transportmittel 15 rotiert, ausgeführt. Durch die Synchronisationen mit dem Antrieb der Fördermittel ergeben sich ohne weitere Steuerungsmaßnahmen stetes die korrekten Zeitpunkte für den Beginn und für das Ende der ausgeschwenkten Lage der Blenden 17. Das Rückschwenken erfolgt durch z.B. Federkraft. Die Zugfeder 20, wie auch die Nocke 19, können symmetrisch am unteren Transportmittel 15 für die Blenden 17 von zwei benachbarten Düsenstöcken 3 angeordnet sein. Die Blenden 17 werden abwechselnd geschwenkt. Dies erfordert auch nur ein besonders eingedrehtes und ausgestattetes unteres Transportmittel 15 an jeder zweiten Position der Durchlaufanlage in Transportrichtung. Die Nockensteuerung benötigt keine zusätzlichen Maßnahmen zur Steuerung und keinen zusätzlichen Antrieb. Von daher ist diese Ausführung der Erfindung, nach der die Nocken mit dem Antrieb der Fördermittel synchronisiert sind und die Bewegung ausführen, so dass die Verlagerung der Blenden zeitgerecht gesteuert wird, sehr kostengünstig.

Die Blenden lassen sich jedoch auch mittels elektrisch oder pneumatisch gesteuerter Antriebe als Motoren oder Zylinder verlagern. Dies ist insbesondere dann erforderlich, wenn Gut mit unterschiedlicher Länge in der Durchlaufanlage behandelt werden soll. In diesem Falle müssen zur Steuerung der Blendenbewegungen die Querlücken von Sensoren erfasst werden.

Die Laschen 18 sind z.B. an einem Drehpunkt 21 am Boden 22 des Arbeitsbehälters gelagert. In Ruhestellung der Laschen 18 gelangt die Behandlungsflüssigkeit als Schwall 23 an die Unterseite des Gutes 1, wodurch ein intensiver Stoffaustausch an dieser Seite erfolgt. Die verlagerbaren Blenden 17 ermöglichen einen dauerhaft gleichbleibenden Druck in den Düsenstöcken 3. Dadurch können die Schwalle mittels der Blenden 17 sehr schnell unterbrochen und auch wieder freigegeben werden. Dies ist besonders bei einer großen Transportgeschwindigkeit vorteilhaft, weil das Gut näher an den vorlaufenden und rücklaufenden Kanten vom Schwall erfasst werden kann.

Damit die Behandlungsflüssigkeit auch im Bereich der Längslücken 12 nicht an die Oberseite des Gutes gelangen kann, werden die Düsen 5 oder Düsenlöcher an den Düsenstöcken 3 ebenso partiell ausgeführt, wie bei der Ausführung der Erfindung gemäß der Figur 1. Im Bereich der Längslücken 12 gibt es keine Düsen 5. Es besteht auch die Möglichkeit, feststehende Längsblenden im Bereich der Längslücken 12 anzuordnen. In diesem Falle können die Düsen 5 an den Düsenstöcken 3 durchgehend angeordnet sein. Durch diese Längsblenden an der Unterseite des Gutes wird dann die Oberseite des Gutes trocken gehalten.

### Liste der Bezugszeichen und Abkürzungen

- 1: Gut, Substrat
- 2: Transportrichtungspfeil, Transportrichtung
- 3: Düsenstock, Sprührohr
- 4: Querlücke
- 5: Düse, Düsenloch
- 6: Ventil
- 7: Verteilerleitung, Rohr
- 8: Pumpe
- 9: Ventil
- 10: Verteilerleitung, Rohr
- 11: Speiserohr
- 12: Längslücke
- 13: Niveau
- 14: oberes Transportmittel, Fördermittel
- 15: unteres Transportmittel, Fördermittel
- 16: Welle
- 17: Blende
- 18: Lasche
- 19: Nocke
- 20: Zugfeder
- 21: Drehpunkt
- 22: Boden
- 23: Schwall
- 24: Wellenabstand
- Lg: Länge des Gutes
- Lqlü: Länge der Querlücke
- Lgbr: Bruttogutlänge = Lg + Lqlü

## Patentansprüche

1. Vorrichtung zur Nassbehandlung der Unterseite von Gut (1) in bevorzugt gleich großen Abschnitten, das nacheinander mindestens von unteren rotierenden Transportmitteln (14) in einer Durchlaufanlage gefördert wird, mittels spritzender oder schwallender Behandlungsflüssigkeit aus Düsenstöcken (3), wobei die Behandlungsflüssigkeit nicht bis an die Oberseite des Gutes heranreicht, **dadurch gekennzeichnet, dass** schaltende oder verlagerbare Mittel in der Durchlaufanlage vorgesehen sind, die mit dem Antrieb der Transportmittel synchronisiert derart steuerbar sind, dass nur die Unterseite der Güter vom Schwall oder von den Spritzstahlen der Behandlungsflüssigkeit erfasst wird.

2. Vorrichtung nach Patentanspruch 1, **dadurch gekennzeichnet, dass** die schaltenden oder verlagerbaren Mittel als schaltbare Ventile (9) und/oder Pumpen (8) ausgeführt sind, die nur dann Behandlungsflüssigkeit über Rohre (7, 10) in die Düsenstöcke (3) freigeben und/oder fördern, wenn sich in ihrem Schwall- oder Spritzbereich ein Gut befindet.

3. Vorrichtung nach Patentanspruch 1, **dadurch gekennzeichnet, dass** die Mittel als verlagerbare Blenden (17) ausgeführt sind, die nur dann den Weg der Behandlungsflüssigkeit von den Düsenstöcken zur Unterseite des Gutes freigeben, wenn sich in ihrem jeweiligen Schwall- oder Spritzbereich ein Gut befindet.

4. Vorrichtung nach einem der Patentansprüche 1 bis 3, **dadurch gekennzeichnet, dass** durch ein Gut, das in Transportrichtung (2) stets gleich lang ist und das fortlaufend mit gleich langer Querlücke (4) beschickt wird, in Verbindung mit synchronisierten Antriebsmitteln der Durchlaufanlage und mit einem Umfang jedes Antriebsmittels, der in einer festen mathematischen Beziehung zur Länge des Gutes plus der Länge der Querlücke steht, die Schaltpunkte der Ventile und/oder Pumpen oder die Verlagerung der Blenden in der gesamten Durchlaufanlage gleichbleibend zeitlich vorbestimmt sind.

5. Vorrichtung nach einem der Patentansprüche 1 bis 4, **dadurch gekennzeichnet, dass** der Umfang jedes Antriebsmittels der Länge des Gutes plus der Länge der Querlücke entspricht oder ein ganzzahliges Vielfaches dieser Summe ist.

6. Vorrichtung nach einem der Patentansprüche 1 bis 5, **gekennzeichnet durch** eine Nockensteuerung oder **durch** synchronisierte elektrische oder pneumatische Antriebe zur Verlagerung der Blenden (17).

7. Vorrichtung nach einem der Patentansprüche 1 bis 6, **gekennzeichnet durch** rotierende Transportmittel (15), auf den sich jeweils mindestens eine Nocke (19) zur Verlagerung der Blenden (17) befindet.

8. Vorrichtung nach einem der Patentansprüche 1 bis 7, **gekennzeichnet durch** ein Transportmittel mit einer darauf befindlichen Nocke zur Steuerung von zwei Blenden an den zwei benachbarten Düsenstöcken.

9. Vorrichtung nach einem der Patentansprüche 1 bis 8, **gekennzeichnet durch** eine Zugfeder (20), die zwei Blenden in ihre Ruhelage zieht.

10. Vorrichtung nach einem der Patentansprüche 1 bis 9, **gekennzeichnet durch** Düsenstöcke, die im Bereich der Längslücken (12) keine Düsen (5) aufweisen.

11. Vorrichtung nach einem der Patentansprüche 1 bis 9, **gekennzeichnet durch** feststehend angeordnete Längsblenden im Bereich der Längslücken (12).

12. Verfahren zur Nassbehandlung der Unterseite von Gut (1) in bevorzugt gleich großen Abschnitten, das nacheinander mindestens von unteren rotierenden Transportmitteln (14) in einer Durchlaufanlage gefördert wird, mittels spritzender oder schwallender Behandlungsflüssigkeit aus Düsenstöcken (3), wobei die Behandlungsflüssigkeit nicht bis an die Oberseite des Gutes heranreicht, unter Verwendung der Vorrichtung nach Patentanspruch 1, **dadurch gekennzeichnet, dass** schaltende oder verlagerbare Mittel die Schwalle oder Spritzstrahlen durch eine Synchronisation mit den Fördermitteln der Durchlaufanlage nur dann in Richtung zur Unterseite der Güter freigeben und diese nassbehandeln, wenn sich in dem Schwall- oder Spritzbereich der Düsenstöcke Güter befinden.

13. Verfahren nach Patentanspruch 12, **dadurch gekennzeichnet, dass** die Mittel zur Freigabe der Schwalle oder Spritzstrahlen durch synchronisierte Antriebe der rotierenden Transportmittel gesteuert werden, die ihrerseits einen Umfang haben, der der Länge des Gutes in Transportrichtung plus der Länge der Querlücke in der selben Richtung entspricht.

14. Verfahren nach Patentanspruch 12, **dadurch gekennzeichnet, dass** mittels Pumpen (8) und/oder Ventilen (6, 9) und durch die Steuerung der Durchlaufanlage einzelne Düsenstöcke oder Gruppen von Düsenstöcken synchronisiert ein- und ausgeschaltet werden.

15. Verfahren nach den Patentansprüchen 12 und 13, **dadurch gekennzeichnet, dass** verlagerbare Blenden (17) die Schwalle oder Spritzstrahlen synchronisiert zeitweise unterbrechen.
